# FASCICULE DE BREVET EUROPEEN

(11) **EP 3 471 151 B1**
(45) Date de publication et mention de la délivrance du brevet: **19.02.2020**
(21) Numéro de dépôt: 18197749.7
(22) Date de dépôt: 28.09.2018
(51) Int. Cl.: H01L 31/0352, H01L 31/105

(54) **PHOTODETECTEUR A RESONATEUR DE HELMHOLTZ**
HELMHOLTZ-RESONATOR-PHOTODETEKTOR
HELMHOLTZ RESONATOR PHOTODETECTOR

(30) Priorité: 13.10.2017 FR 1759597
(43) Date de publication de la demande: 17.04.2019
(73) Titulaire: Office National d'Etudes et de Recherches Aérospatiales, 91120 Palaiseau (FR); Centre National de la Recherche Scientifique - CNRS, 75016 Paris (FR)
(72) Inventeur: STEVELER, Emilie, 67100 STRASBOURG (FR); CHEVALIER, Paul, 17450 FOURAS (FR); PELOUARD, Jean-Luc, 75020 PARIS (FR); PARDO, Fabrice, 94400 VITRY SUR SEINE (FR); BOUCHON, Patrick, 91370 VERRIERES LE BUISSON (FR); HAIDAR, Riad, 75012 PARIS (FR); VERDUN, Michaël, 22300 Lannion (FR)
(74) Mandataire: Plasseraud IP

(56) Documents cités:
- CHANGLEI ZHANG ET AL: "Dual-band wide-angle metamaterial perfect absorber based on the combination of localized surface plasmon resonance and Helmholtz resonance", SCIENTIFIC REPORTS, vol. 7, no. 1, 18 juillet 2017 (2017-07-18), XP055478739, DOI: 10.1038/s41598-017-06087-1
- COLLIN STÉPHANE ET AL: "Efficient light absorption in metal-semiconductor-metal nanostructures", APPLIED PHYSICS LETTERS, A I P PUBLISHING LLC, US, vol. 85, no. 2, 1 janvier 2004 (2004-01-01), pages 194-196, XP012063339, ISSN: 0003-6951, DOI: 10.1063/1.1771467
- PAUL CHEVALIER ET AL: "Optical Helmholtz resonators", APPLIED PHYSICS LETTERS, vol. 105, no. 7, 18 août 2014 (2014-08-18) , page 071110, XP055478745, US ISSN: 0003-6951, DOI: 10.1063/1.4893786

## Description

La présente invention concerne un photodétecteur, un procédé de fabrication d'un tel photodétecteur, ainsi qu'un capteur d'image.

Les photodétecteurs sont des composants optroniques qui sont fondamentaux pour de nombreuses applications, parmi lesquelles la photographie numérique et les communications optiques. Chaque photodétecteur a la fonction de détecter un flux de rayonnement électromagnétique, et de convertir ce flux en une grandeur électrique qui peut ensuite être lue par un circuit électronique.

Les photodétecteurs les plus utilisés de nos jours sont des photodiodes fabriquées en technologie CMOS. Toutefois, les photodiodes ne possèdent pas une sélectivité suffisante par rapport à la longueur d'onde du rayonnement électromagnétique qui est incident, puisqu'il suffit que cette longueur d'onde corresponde à une énergie de photon qui est supérieure à la bande interdite du matériau semiconducteur utilisé, pour que le rayonnement soit détecté. En outre, les photodiodes ne présentent pas non plus de sélectivité en fonction de l'état de polarisation du rayonnement électromagnétique. Pour ces raisons, lorsqu'une détection du rayonnement est recherchée, qui permette de distinguer des couleurs différentes ou des états différents de polarisation, chaque photodiode doit être combinée avec un filtre spectral ou un polariseur. Ces composants optiques additionnels génèrent des coûts de fabrication supplémentaires, ainsi qu'une complexité d'assemblage pour les disposer par rapport aux photodétecteurs, notamment au sein d'un capteur d'image en couleurs.

Des photodétecteurs quantiques qui sont efficaces dans les fenêtres spectrales 3-5 µm (micromètre) et 8-14 µm sont aussi connus, mais ils nécessitent d'être refroidis à des températures cryogéniques, typiquement à moins de 77 K (kelvin). Cette contrainte de refroidissement constitue une limitation à leur utilisation, voire un empêchement, surtout pour des appareils qui seraient destinés au grand public, et augmente leur prix de revient dans une mesure importante.

D'autres types de photodétecteurs qui sont efficaces dans la bande spectrale de 0,3 µm à 15 µm sont aussi connus, tels que des antennes quart d'onde, par exemple sous la forme de fentes ou de structures métal-isolant-métal. Mais les combinaisons de caractéristiques qu'ils présentent, entre leur niveau de sensibilité de détection d'une part et la largeur de leur intervalle spectral de détection d'autre part, ne sont pas adaptées pour des applications telles que l'imagerie.

Par ailleurs, on connaît des résonateurs de Helmholtz à champ électromagnétique. Un tel résonateur comprend :
- un volume isolant électriquement ; et
- des faces métalliques qui entourent le volume isolant le long d'au moins un chemin en boucle autour de ce volume isolant, en dehors de deux interruptions du chemin en boucle, de sorte que les faces métalliques constituent deux électrodes qui sont séparées l'une de l'autre par au moins un intervalle, dit intervalle de concentration du champ électrique et qui contient les interruptions du chemin en bouche.

Dans un tel résonateur de Helmholtz, l'intervalle de concentration du champ électrique a une épaisseur entre les deux électrodes qui est plus petite qu'une épaisseur du volume isolant, ces épaisseurs étant mesurées selon une direction commune. Ainsi, lorsque du rayonnement électromagnétique est incident sur le résonateur, un champ électrique qui est créé par ce rayonnement dans le résonateur est beaucoup plus intense dans l'intervalle de concentration du champ électrique que dans le volume isolant.

De plus, l'Homme du métier sait comment sélectionner des dimensions du volume isolant et des faces métalliques d'un tel résonateur, pour produire une résonance du champ électrique dans l'intervalle de concentration du champ électrique, à une longueur d'onde voulue pour le rayonnement électromagnétique.

La publication *"*Dual band wide-angle metamaterial perfect absorber based on the combination of localized surface plasmon resonance and Helmholtz resonance", ZHANG et al., Scientific Reports, vol. 7, no. 1, 18 juillet 2017, divulgue un photodétecteur à résonateur Helmholtz. A partir de cette situation, un but de la présente invention est de disposer de nouveaux photodétecteurs, chacun avec un intervalle spectral de détection et une sélectivité par rapport à la polarisation du rayonnement électromagnétique à détecter qui peuvent être choisis à volonté.

Un autre but est de disposer de tels photodétecteurs qui possèdent un large champ angulaire de détection, et/ou une section efficace de détection importante, et/ou des dimensions réduites notamment pour permettre de réaliser des capteurs d'image à résolution fine.

Un autre but encore est de disposer de tels photodétecteurs qui puissent être fabriqués à coût modéré ou faible, et qui ne nécessitent pas de refroidissement pour leur fonctionnement.

Pour cela, un premier aspect de l'invention propose un photodétecteur à résonateur de Helmholtz, qui est efficace pour détecter au moins un rayonnement électromagnétique ayant une longueur d'onde comprise entre 0,3 µm et 15 µm. Le photodétecteur comprend le résonateur de Helmholtz, avec son volume isolant et des faces métalliques qui ont des dimensions adaptées pour produire une résonance du champ électrique dans l'intervalle de concentration du champ électrique lorsque la longueur d'onde du rayonnement varie entre 0,3 µm et 15 µm.

Le photodétecteur de l'invention comprend en outre :
- au moins une structure photosensible, qui est à base d'au moins un matériau semiconducteur, qui est absorbante pour le rayonnement, qui est disposée au moins en partie dans l'intervalle de concentration du champ électrique, et qui est en contact électrique avec chacune des deux électrodes ; et
- deux connexions électriques de sortie, qui sont reliées électriquement une-à-une aux deux électrodes, et adaptées pour transmettre un signal électrique de détection qui est généré dans la structure photosensible lorsque le rayonnement est incident sur le résonateur de Helmholtz.

En outre, la structure photosensible possède un intervalle spectral de détection qui contient un intervalle spectral de la résonance du champ électrique. Par analogie avec le domaine acoustique, cette dernière condition peut être appelée condition d'accord de la structure photosensible avec le résonateur.

Ainsi, dans un photodétecteur conforme à l'invention, le résonateur de Helmholtz possède une fonction d'exaltation du champ électrique qui est généré par le rayonnement électromagnétique. Cette exaltation est produite dans l'intervalle de concentration du champ électrique. Alors, du fait que la structure photosensible soit disposée dans cet intervalle de concentration du champ électrique, le photodétecteur présente une sensibilité élevée, si bien qu'il peut détecter des rayonnements électromagnétiques dont les intensités sont faibles, voire très faibles.

En outre, le résonateur de Helmholtz possède la fonction d'un filtre du rayonnement électromagnétique incident, effectif par rapport à la longueur d'onde de ce rayonnement. Le filtre qui est ainsi constitué par le résonateur de Helmholtz possède une largeur spectrale de résonance qui suffisante pour de nombreuses applications, notamment des applications d'imagerie, grâce aux valeurs relativement faibles des facteurs de qualité des résonateurs de Helmholtz pour rayonnement électromagnétique.

Par ailleurs, le résonateur de Helmholtz étant sensible au rayonnement électromagnétique incident à l'intérieur d'un large secteur angulaire pour la direction d'incidence du rayonnement, le photodétecteur de l'invention possède lui-même un champ angulaire de détection qui est large. Il peut donc être associé à une lentille à grande ouverture numérique, pour focaliser le rayonnement sur le photodétecteur avec une aire de collecte du rayonnement qui est agrandie.

De plus, grâce à l'utilisation du résonateur de Helmholtz, le photodétecteur possède une section efficace de détection qui est importante.

Enfin, un photodétecteur qui est conforme à l'invention peut posséder une épaisseur qui est très faible, notamment inférieure à la longueur d'onde du rayonnement détecté. Cette épaisseur très faible procure les avantages supplémentaires suivants : une valeur de courant d'obscurité qui peut être très basse, un meilleur contrôle des transitions radiatives qui sont utilisées dans la structure photosensible, un transport électrique qui est dominé par l'effet de dérive, et un temps de transit des photo-porteurs qui est très court.

Dans des premières configurations de photodétecteurs à résonateurs de Helmholtz qui sont conformes à l'invention, le volume isolant électriquement peut être rectiligne et allongé dans une première direction, et chaque intervalle de concentration du champ électrique peut alors aussi être rectiligne et allongé dans la même première direction. De tels photodétecteurs sont sélectifs par rapport à la polarisation du rayonnement électromagnétique, en étant sensibles principalement au rayonnement qui est polarisé linéairement et dont le champ magnétique est parallèle à la direction d'élongation du volume isolant et de l'intervalle de concentration du champ électrique.

Dans des secondes configurations de photodétecteurs à résonateurs de Helmholtz qui sont aussi conformes à l'invention, le volume isolant électriquement peut posséder deux branches rectilignes et allongées qui sont perpendiculaires l'une à l'autre. Dans ce cas, chaque intervalle de concentration du champ électrique peut comprendre avantageusement, pour chaque branche du volume isolant, un segment d'intervalle qui est aussi rectiligne et allongé parallèlement à cette branche, et qui comprend un segment de la structure photosensible. Un photodétecteur qui possède une telle seconde configuration est sensible simultanément et dans des mesures qui sont équivalentes, à tous les états de polarisation possibles pour le rayonnement électromagnétique. Le photodétecteur produit ainsi un signal de détection qui est représentatif de l'intensité du rayonnement, sommée sur tous ses états de polarisation.

De façon générale, les faces métalliques du résonateur de Helmholtz peuvent former d'une part une cuvette ayant un fond et deux faces latérales qui s'étendent continûment à partir de deux côtés opposés du fond, et former d'autre part une face de couvercle qui est en vis-à-vis du fond. Le volume isolant est alors situé entre le fond de la cuvette et la face de couvercle, et simultanément entre les deux faces latérales de la cuvette. En outre, chaque intervalle de concentration du champ électrique est situé entre un bord latéral de la face de couvercle et un bord de l'une des faces latérales de la cuvette qui est opposé au fond de la cuvette. Préférablement, les deux faces latérales de la cuvette peuvent être parallèles et séparées par une largeur de cuvette qui est comprise entre 0,05 µm et 0,25 µm. Simultanément, le fond de la cuvette et la face de couvercle peuvent être parallèles et séparées par une épaisseur du volume isolant qui est comprise entre 0,03 µm et 0,25 µm. Pour cela, la direction de hauteur du volume isolant est mesurée perpendiculairement à la direction de largeur de la cuvette.

Aussi de façon générale pour l'invention, l'épaisseur de chaque intervalle de concentration du champ électrique, lorsqu'elle est mesurée d'une électrode à l'autre, peut être comprise entre 10 nm et 100 nm, et chaque intervalle de concentration du champ électrique peut avoir une largeur, mesurée parallèlement à l'une au moins des électrodes au niveau de l'intervalle de concentration du champ électrique considéré, qui est comprise entre 10 nm et 50 nm.

Encore de façon générale pour l'invention, chaque électrode peut être constituée au moins en partie par l'un des métaux suivants : or, argent, cuivre, aluminium, ou par un alliage qui comprend l'un au moins de ces métaux.

Dans divers modes de réalisation de l'invention, chaque structure photosensible peut comprendre l'un parmi une jonction PiN, une portion d'un matériau semiconducteur, et un empilement multicouche à puits quantique.

Possiblement, le photodétecteur peut comprendre en outre une structure de lentille convergente qui est disposée fixement par rapport au résonateur de Helmholtz. Une telle structure de lentille peut focaliser le rayonnement sur le résonateur de Helmholtz, lorsque ce rayonnement est incident sur la structure de lentille. Dans ce cas, le photodétecteur peut encore comprendre en outre une couche d'un matériau transparent pour le rayonnement, qui est disposée entre le résonateur de Helmholtz et la structure de lentille. Cette couche possède une fonction d'espaceur entre le résonateur de Helmholtz et la structure de lentille. Ainsi, le résonateur de Helmholtz, chaque structure photosensible, la couche du matériau transparent et la structure de lentille peuvent être solidaires au sein d'un bloc rigide. La manipulation du photodétecteur et son assemblage dans un appareil sont ainsi facilités. En particulier, la structure de lentille peut comprendre une couche métallique qui est munie d'un trou en vis-à-vis du résonateur de Helmholtz, et munie en outre de fentes qui sont disposées autour du trou pour constituer une lentille de Huygens.

Un deuxième aspect de l'invention propose un procédé de fabrication d'un photodétecteur, lorsque ce photodétecteur est conforme au premier aspect de l'invention. Le procédé comprend les étapes suivantes :
/1/ sur un support temporaire, formation de chaque structure photosensible et d'une portion de matériau isolant électriquement en tant que volume isolant, puis formation d'une première des électrodes par-dessus la structure photosensible et le volume isolant ;
/2/ adhésion d'un support définitif sur la première électrode, d'un côté de celle-ci qui est opposé au support temporaire ;
/3/ retrait du support temporaire ; et
/4/ dépôt d'une seconde des électrodes sur la structure photosensible et la portion de matériau isolant, d'un côté de ceux-ci qui est opposé au support définitif.

Enfin, un troisième aspect de l'invention propose un capteur d'image qui comprend :
- une matrice de photodétecteurs conformes chacun au premier aspect de l'invention, ces photodétecteurs étant disposés à des croisements de lignes et de colonnes de la matrice ;
- un système d'adressage, adapté pour sélectionner chaque photodétecteur individuellement ; et
- un système de lecture, adapté pour lire le signal électrique de détection qui est transmis par les deux connexions électriques de sortie de l'un quelconque des photodétecteurs lorsque ce photodétecteur est sélectionné par le système d'adressage.

Un tel capteur d'image peut avoir un pas de lignes ou de colonnes qui est compris entre 2 µm et 20 µm lorsque chaque photodétecteur est efficace pour détecter un rayonnement dont la longueur d'onde est comprise entre 0,8 µm et 15 µm, correspondant ou domaine infrarouge optique.

Alternativement, le pas de lignes ou de colonnes peut être compris entre 0,1 µm et 2 µm lorsque chaque photodétecteur est efficace pour détecter un rayonnement dont la longueur d'onde est comprise entre 0,3 µm et 0,8 µm, correspondant au domaine de la lumière visible.

D'autres particularités et avantages de la présente invention apparaîtront dans la description ci-après d'exemples de réalisation non limitatifs, en référence aux dessins annexés, dans lesquels :
- la figure 1 est une vue en section transversale d'un photodétecteur conforme à l'invention ;
- les figures 2a et 2b sont des vues en perspective de deux photodétecteurs conformes à l'invention, selon deux configurations différentes ;
- la figure 3a illustre un premier mode de réalisation pour une structure photosensible d'un photodétecteur conforme à l'invention, et la figure 3b est un diagramme spectral de réflectivité pour le photodétecteur de la figure 3a ;
- la figure 4 correspond à la figure 3b pour un deuxième mode de réalisation de la structure photosensible ;
- les figures 5a et 5b correspondent respectivement aux figures 3a et 3b, pour un troisième mode de réalisation de la structure photosensible ;
- les figures 6a à 6h sont des vues en section d'un ensemble de photodétecteurs conformes à l'invention, en cours d'élaboration, qui illustrent des étapes d'un procédé de fabrication de ces photodétecteurs ;
- la figure 7 est une vue en section transversale d'un photodétecteur conforme à l'invention, qui est muni d'une structure de lentille ; et
- la figure 8 est une vue en perspective d'un capteur d'image conforme à l'invention.

Pour raison de clarté, les dimensions des éléments qui sont représentés dans ces figures ne correspondent ni à des dimensions réelles ni à des rapports de dimensions réels. En outre, des références identiques qui sont indiquées dans des figures différentes désignent des éléments identiques ou qui ont des fonctions identiques.

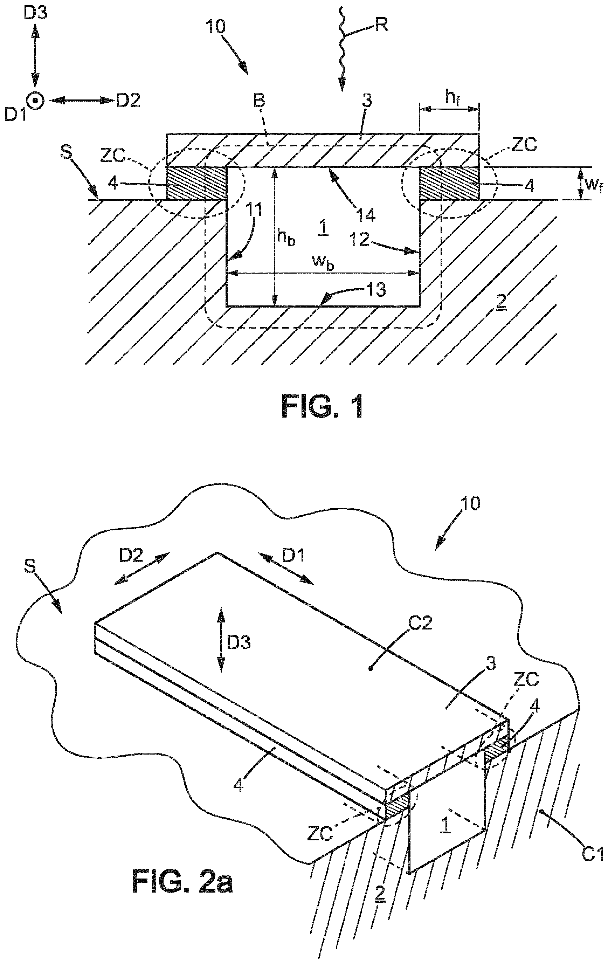

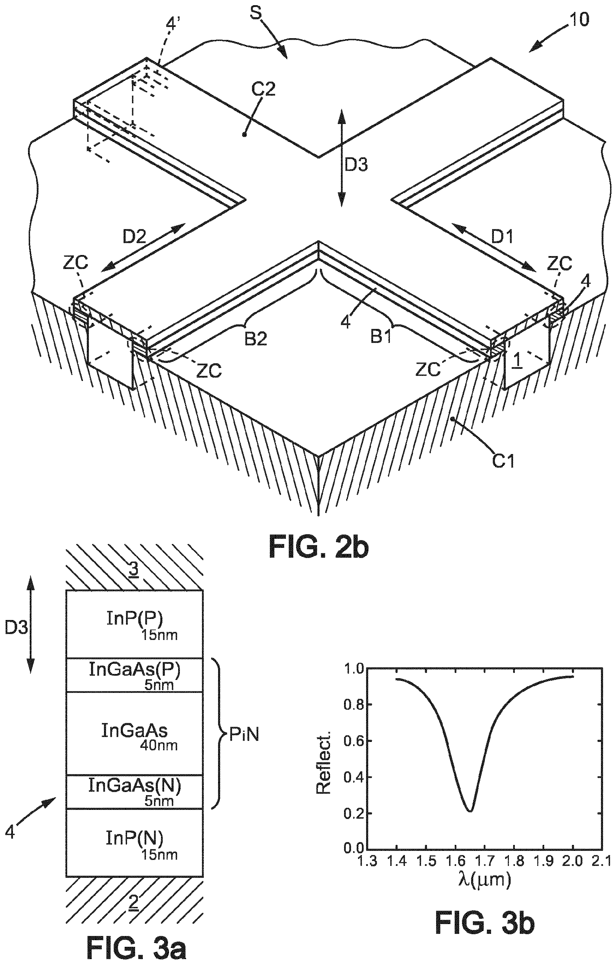

Conformément aux figures 1, 2a et 2b, un photodétecteur 10 conforme à l'invention comprend une couche de base 2 qui possède une surface plane S, un volume isolant électriquement 1, une portion de couvercle 3 et une structure intermédiaire 4. La couche de base 2 est en matériau métallique, de préférence avec une conductivité électrique qui est élevée. Par exemple, la couche de base 2 peut être en or (Au) ou en cuivre (Cu). Le volume isolant 1 peut être constitué par une portion d'un matériau isolant électriquement, tel que de la silice (SiO₂), qui est enchâssée dans la couche de base 2 pour une partie principale de cette portion. La portion de couvercle 3 est aussi en matériau métallique, de préférence encore avec une conductivité électrique qui est élevée, et donc possiblement aussi en or. Ainsi, la couche de base 2 présente une forme de cuvette parallélépipédique à partir de sa surface S, avec des faces latérales opposées 11 et 12, un fond de cuvette 13 et une face inférieure 14 de la portion de couvercle 3, cette face inférieure 14 étant tournée vers l'intérieur de la cuvette.

La structure intermédiaire 4 sera décrite en détail plus loin. Elle est située entre la surface S de la couche de base 2 et la face inférieure 14 de la portion de couvercle 3, autour du volume isolant 1. Elle est en contact électrique d'une part avec la couche de base 2, et d'autre part avec la portion de couvercle 3. La couche de base 2 et la portion de couvercle 3 sont isolés électriquement l'une de l'autre en dehors de la structure intermédiaire 4. Sauf indication contraire, on pourra supposer dans la suite que la structure intermédiaire 4 est continue autour du volume isolant 1. Toutefois, elle peut être limitée à un ou plusieurs segments de la périphérie du volume isolant 1, tant que la couche de base 2 et la portion de couvercle 3 sont isolés électriquement l'un de l'autre en dehors de la structure intermédiaire 4.

La portion de matériau isolant remplit la cuvette qui est formée dans la couche de base 2, avec la structure intermédiaire 4 qui forme une entretoise périphérique entre la surface S et la portion de couvercle 3. Les notations qui sont indiquées dans la figure 1 ont les significations suivantes :
- w_{b}: largeur du volume isolant 1, mesurée entre les faces latérales 11 et 12 parallèlement à la direction D2
- h_{b}: épaisseur du volume isolant 1, mesurée entre le fond de cuvette 13 et la face inférieure 14 de la portion de couvercle 3, parallèlement à la direction D3
- w_{f}: épaisseur de la structure intermédiaire 4, mesurée parallèlement à la direction D3
- h_{f}: largeur de la structure intermédiaire 4, mesurée parallèlement à la direction D2

La boucle B qui est indiquée dans la figure 1 entoure le volume isolant 1, en étant contenue dans la couche de base 2 et dans la portion de couvercle 3, et en traversant la structure intermédiaire 4 à deux endroits qui sont situés entre la couche de base 2 et la portion de couvercle 3. La longueur de chaque segment de la boucle B qui est contenu dans la structure intermédiaire 4 est sensiblement égale à l'épaisseur w_{f}. En outre, cette épaisseur w_{f} de la structure intermédiaire 4 est inférieure, de préférence très inférieure, à l'épaisseur h_{b} du volume isolant 1. Dans ces conditions, la partie de la surface S de la couche de base 2 qui est en vis-à-vis du bord périphérique de la portion de couvercle 3, forme avec ce bord de couvercle deux armatures d'un condensateur électrique. L'espace qui est intermédiaire entre ces deux armatures de condensateur est noté ZC. Il est réparti entre les deux côtés du volume isolant 1 et constitue un intervalle de concentration du champ électrique, par rapport à une intensité du champ électrique qui peut exister à l'intérieur du volume isolant 1. Cet effet de concentration du champ électrique a été appelé exaltation dans la partie générale de la présente description. Il est quantifié par un facteur d'exaltation G, qui est égal au carré du quotient de l'intensité du champ électrique dans l'intervalle de concentration ZC, sur l'intensité du champ électrique dans le volume isolant 1. Une valeur approximative de ce facteur d'exaltation est alors donnée par la formule suivante : G = λ²/(ε_{SC}·w_{f}·h_{f}), où λ est la longueur d'onde du rayonnement électromagnétique R, et ε_{SC} est la permittivité diélectrique relative par rapport au vide du matériau qui constitue la structure intermédiaire 4.

Une telle structure constitue un résonateur de Helmholtz, pour lequel l'intensité du champ électrique dans l'intervalle de concentration ZC présente une résonance en fonction de la longueur d'onde du rayonnement électromagnétique R qui est incident sur l'ensemble de cette structure. La longueur d'onde centrale de la résonance est donnée par la formule connue de l'Homme du métier : λᵣ = 2·π·[ε_{SC}·w_{b}·h_{b}·h_{f}/(2·w_{f})]^{1/2}. Pour les formules de G et λᵣ qui viennent d'être données, la longueur du volume isolant 1 et de la structure intermédiaire 4, perpendiculairement au plan de la figure 1, c'est-à-dire parallèlement à la direction D1, est supposée beaucoup plus grande que les dimensions w_{b}, h_{b}, w_{f} et h_{f}. Autrement dit, le volume isolant 1 et la structure intermédiaire 4 sont allongés parallèlement à la direction D1, dite direction d'élongation.

Par exemple, lorsque la couche de base 2 et la portion de couvercle 3 sont en or (Au), le volume isolant 1 en silice (SiO₂), et l'indice de réfraction moyen de la structure intermédiaire 4 est de l'ordre de 3,5, les dimensions suivantes peuvent être utilisées pour le résonateur de Helmholtz : w_{b} = 0,11 µm (micromètre), h_{b} = 0,10 µm, w_{f} = 15 nm (nanomètre) et h_{f} = 30 nm. Dans ces conditions, et lorsque le rayonnement électromagnétique R possède une polarisation linéaire telle que son champ magnétique est parallèle à la direction d'élongation D1, la longueur d'onde de résonance λᵣ est environ égale à 3,25 µm, le facteur d'exaltation G pour cette longueur d'onde est supérieur à 100, alors que le facteur de qualité Q du résonateur de Helmholtz n'est que de l'ordre de 10. Cette valeur faible du facteur de qualité Q du résonateur de Helmholtz permet au photodétecteur 10 d'avoir une largeur spectrale de détection qui est suffisante pour de nombreuses applications, notamment des applications d'imagerie. En outre, ces valeurs numériques de λᵣ, G et Q sont peu modifiées pour des inclinaisons de la direction d'incidence du rayonnement R qui varient entre 0° (degré) et 40°, par rapport à la direction D3 qui est perpendiculaire à la surface S. Pour cette raison, le photodétecteur 10 peut être efficacement combiné avec une lentille de focalisation qui possède une valeur élevée d'ouverture numérique. Ainsi, la détection du rayonnement électromagnétique R est effective dans une aire de collecte de ce rayonnement qui est agrandie.

Comme indiqué plus haut, l'efficacité du résonateur de Helmholtz à exalter le champ électrique du rayonnement R dans l'intervalle de concentration ZC est supérieure lorsque ce rayonnement possède une polarisation linéaire telle que son champ magnétique soit parallèle à la direction d'élongation du volume isolant 1. Ainsi, le photodétecteur 10 de la figure 2a possède une sensibilité supérieure pour le rayonnement R lorsque ce rayonnement possède une polarisation linéaire telle que son champ magnétique soit parallèle à la direction D1.

Dans le photodétecteur 10 de la figure 2b, le volume isolant 1 possède deux branches B1 et B2, qui sont rectilignes, allongées, perpendiculaires l'une à l'autre, et parallèles aux directions D1 et D2, respectivement. La branche B1 possède ainsi une capacité supérieure à exalter le champ électrique du rayonnement électromagnétique R lorsque ce rayonnement possède une polarisation linéaire telle que son champ magnétique soit parallèle à la direction D1. Simultanément, la branche B2 possède une capacité supérieure à exalter le champ électrique du rayonnement électromagnétique R lorsque ce rayonnement possède une polarisation linéaire telle que son champ magnétique soit parallèle à la direction D2. Par combinaison, un tel photodétecteur 10 permet d'exalter le rayonnement R quelle que soit sa polarisation, et est ainsi particulièrement adapté pour détecter du rayonnement qui présente une polarisation naturelle. De préférence, l'intervalle de concentration ZC du champ électrique s'étend le long d'au moins une partie de chaque bras B1, B2, comprenant ainsi au moins deux segments d'intervalle qui sont rectilignes et allongés parallèlement aux directions D1 et D2, respectivement.

Selon l'invention, la structure intermédiaire 4 qui est située au moins en partie dans l'intervalle ZC de concentration du champ électrique, est photosensible et en contact électrique d'une part avec la couche de base 2, et d'autre part avec la portion de couvercle 3. Les notations C1 et C2 dans les figures 2a et 2b désignent deux contacts électriques de sortie, qui aboutissent à la couche de base 2 pour C1, et à la portion de couvercle 3 pour C2. Ces contacts électriques de sortie C1 et C2 sont destinés à transmettre, par exemple à un circuit de lecture, un courant ou une tension électrique qui est produite par le rayonnement R dans la structure photosensible 4. Dans la partie générale de la description, la couche de base 2 et la portion de couvercle 3 ont été appelées électrodes, en référence avec la disposition sur celles-ci des contacts électriques de sortie C1 et C2.

Grâce à l'effet d'exaltation du champ électrique du rayonnement R dans l'intervalle de concentration ZC, il est possible d'utiliser pour la structure photosensible 4 des modes de réalisation qui peuvent avoir une efficacité de détection plus faible, mais qui ont des dimensions plus réduites et/ou qui sont plus simples et moins onéreux à fabriquer.

Dans des premiers modes de réalisation possibles, et pour des photodétecteurs 10 qui sont conformes à l'invention, la structure photosensible 4 peut être une jonction PiN, l'acronyme PiN signifiant à trois zones, dopée positivement pour l'une, négativement pour une autre, et avec une zone intermédiaire à conductivité électrique intrinsèque. Comme représenté sur la figure 3a, une telle jonction PiN peut être constituée par un empilement, selon la direction D3, de trois couches d'un alliage d'indium (In), de gallium (Ga) et d'arsenic (As), par exemple selon la stœchiométrie approximative In_{0,53}Ga_{0,47}As. Pour réduire une composante de diffusion du courant d'obscurité, il peut être avantageux d'ajouter deux couches d'un matériau qui présente une valeur de gap supérieure à celle de l'alliage utilisé pour la jonction PiN, par exemple deux couches d'un alliage d'indium (In) et de phosphore (P). En effet, les valeurs de gap respectives des alliages In_{0,53}Ga_{0,47}As et InP sont 0,74 eV (électron-volt) et 1,27 eV. La structure photosensible 4 possède alors la configuration qui est représentée sur la figure 3a, où (P) désigne des couches qui sont dopées positivement, et (N) désigne des couches qui sont dopées négativement. La figure 3a indique aussi des épaisseurs, exprimées en nanomètres (nm) et mesurées selon la direction D3, qui sont possibles pour chaque couche de la structure photosensible 4, correspondant à une épaisseur totale d'environ 80 nm, égale à l'épaisseur w_{f} définie plus haut.

Les dimensions du résonateur de Helmholtz sont sélectionnées pour que ce résonateur soit accordé avec la structure photosensible 4 : l'énergie de photon qui correspond à la longueur d'onde de résonance λᵣ est supérieure à la largeur du gap de l'alliage utilisé pour la jonction PiN, additionnée de k_{B}·T/2, où k_{B} désigne la constante de Boltzmann et T la température de fonctionnement du photodétecteur 10, par exemple égale à 300 K (kelvin) pour une utilisation à température ambiante. Dans ces conditions, la longueur d'onde qui correspond au maximum de sensibilité du photodétecteur 10 ainsi obtenu, est environ égale à 1,650 µm, et le facteur d'exaltation G est d'environ 140 pour cette longueur d'onde, lorsque le champ magnétique du rayonnement R est parallèle à la direction d'élongation du résonateur de Helmholtz. Pour cela, les dimensions du résonateur de Helmholtz peuvent être les suivantes : w_{b} = 0,080 µm, h_{b} = 0,075 µm, w_{f} = 80 nm et h_{f} = 25 nm. Un pas de décalage p, entre plusieurs photodétecteurs 10 qui sont conformes à ces dimensions et à la figure 2a ou 2b, et qui sont juxtaposés dans la surface S en étant décalés selon les directions D1 ou D2, peut être de 1,1 µm. La figure 3b reproduit un diagramme de réflectivité de l'ensemble de photodétecteurs qui est ainsi obtenu, pour le rayonnement R en incidence normale. L'axe horizontal indique les valeurs de la longueur d'onde À, exprimée en micromètres, et l'axe vertical indique les valeurs de la réflectivité, notée Reflect et exprimée en pourcentage. La résonance d'absorption, permettant la détection du rayonnement R, correspond à la valeur de 1,65 µm pour la longueur d'onde.

Par rapport à d'autres photodétecteurs connus avant la présente invention, le rendement de détection individuel de chaque photodétecteur peut être plus faible pour la présente invention. Mais les dimensions de chaque photodétecteur parallèlement à la surface S, qui sont aussi plus faibles pour l'invention, permettent d'obtenir des valeurs pour un rendement de détection par unité de surface, qui sont supérieures à celles obtenues avec les photodétecteurs antérieurs.

Pour réduire des pertes de rendement qui seraient dues à des courants électriques parasites, se produisant à proximité des limites latérales de la structure photosensible 4, celle-ci peut être continue entre le volume isolant 1 et la portion de couvercle 3, et/ou déborder latéralement au-delà des bords latéraux de la portion de couvercle 3.

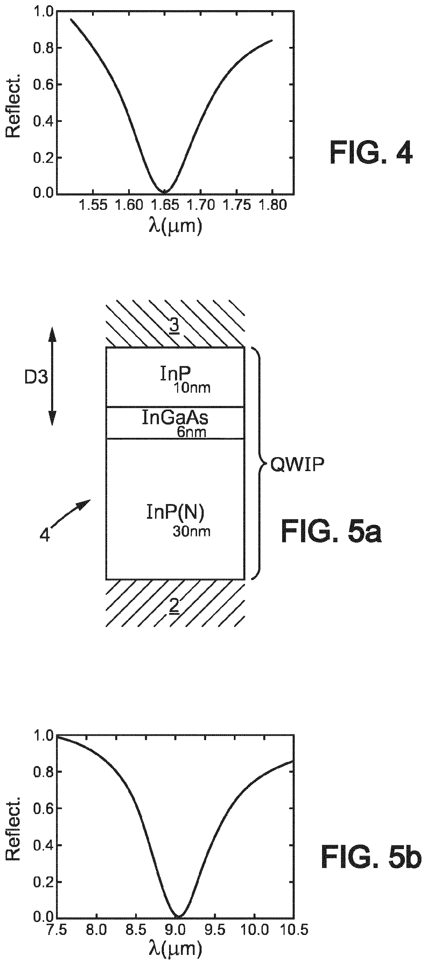

Dans des deuxièmes modes de réalisation, aussi possibles pour des photodétecteurs 10 qui sont conformes à l'invention, la structure photosensible 4 peut être une portion d'un matériau semiconducteur. Cette portion est en contact d'un côté avec la couche de base 2 et de l'autre côté avec la portion de couvercle 3, formant ainsi un empilement métal-semiconducteur-métal. Dans un tel empilement, la portion du matériau semiconducteur a la fonction d'absorber l'énergie du champ électrique exalté, et les deux interfaces métal-semiconducteur constituent deux diodes Schottky. Le matériau semiconducteur d'une telle structure photosensible 4 peut encore être un alliage de type InGaAs, et les dimensions suivantes conduisent encore à valeur de 1,650 µm pour la longueur d'onde de résonance λᵣ du résonateur de Helmholtz : w_{b} = 0,060 µm, h_{b} = 0,050 µm, w_{f} = 30 nm et h_{f} = 20 nm. Le facteur d'exaltation G est alors environ égal à 350 à la longueur d'onde de résonance de 1,650 nm. Cette valeur du facteur G est supérieure à celle du premier mode de réalisation rapporté précédemment, du fait de la valeur plus faible de l'épaisseur w_{f} de la structure intermédiaire 4. La valeur de 1,1 µm peut encore être adoptée pour le pas de décalage p de photodétecteurs multiples qui sont juxtaposés dans la surface S. La figure 4 montre le spectre de réflectivité qui est obtenu dans ces conditions.

De tels deuxièmes modes de réalisation peuvent produire des valeurs d'efficacité de détection qui sont inférieures à celles des premiers modes de réalisation décrits précédemment, individuellement pour chaque photodétecteur 10. Mais ces valeurs individuelles d'efficacité de détection qui sont inférieures peuvent être compensées par une densité supérieure de photodétecteurs dans la surface S, correspondant à des valeurs plus petites pour le pas de décalage p.

Possiblement, des photodétecteurs 10 qui sont conformes à de tels deuxièmes modes de réalisation peuvent être utilisés pour détecter du rayonnement électromagnétique selon un mécanisme non-linéaire d'absorption à deux photons dégénérés, c'est-à-dire à deux photons de longueurs d'onde identiques. Dans ce cas, l'énergie de chacun des deux photons est comprise entre la largeur du gap du matériau semiconducteur de la structure photosensible 4, et la moitié de cette largeur de gap. Par exemple, une énergie de photons qui est égale à 0,41 eV, correspondant à une longueur d'onde de 3 µm, permet une détection par absorption de deux photons lorsque l'alliage semiconducteur InGaAs est utilisé, puisque sa largeur de gap est d'environ 0,74 eV. Le résonateur de Helmholtz doit alors être dimensionné pour produire la résonance à la longueur d'onde des photons, c'est-à-dire 3 µm dans l'exemple considéré. Pour les dimensions suivantes: w_{b} = 0,150 µm, h_{b} = 0,135 µm, w_{f} = 30 nm et h_{f} = 20 nm, le facteur d'exaltation G est environ égal à 1950 pour la longueur d'onde de 3 µm. Un pas de décalage p de 2,0 µm peut alors être utilisé entre de tels photodétecteurs 10 qui sont juxtaposés sur la surface S. Etant donné que le carré du facteur d'exaltation G intervient dans le rendement de détection du rayonnement R par le mécanisme d'absorption à deux photons dégénérés, des photodétecteurs 10 qui sont conformes aux deuxièmes modes de réalisation de l'invention et qui sont utilisés selon ce mécanisme d'absorption à deux photons dégénérés, peuvent être particulièrement adaptés pour détecter des rayonnements à plus grandes valeurs de longueur d'onde.

Dans des troisièmes modes de réalisation, encore possibles pour des photodétecteurs 10 qui sont conformes à l'invention, la structure photosensible 4 peut être une structure à un puits quantique, connue sous l'acronyme QWIP pour «quantum well infrared photodetector» en anglais. Le principe de fonctionnement d'une telle structure à un puits quantique pour détecter un rayonnement électromagnétique est supposé bien connu, si bien qu'il n'est pas nécessaire de le répéter ici. Si nécessaire, le lecteur pourra se reporter à la littérature scientifique concernée, abondante et largement disponible. Il est simplement indiqué que pour de tels troisièmes modes de réalisation, une tension électrique de polarisation doit être appliquée entre les contacts électriques de sortie C1 et C2. La figure 5a représente un exemple d'une telle structure photosensible. La couche d'alliage indium-phosphore de 10 nm d'épaisseur constitue la cathode, la couche intermédiaire d'alliage indium-gallium-phosphore de 6 nm d'épaisseur constitue le puits quantique, et l'autre couche d'alliage indium-phosphore, de 30 nm d'épaisseur, constitue l'anode de la structure QWIP. Dans ces conditions, la structure photosensible 4 est efficace pour détecter du rayonnement électromagnétique dont la longueur d'onde est environ égale à 9 µm. Les dimensions suivantes peuvent être utilisées pour accorder le résonateur de Helmholtz à cette valeur de longueur d'onde de détection : w_{b} = 0,500 µm, h_{b} = 0,620 µm, w_{f} = 46 nm et h_{f} = 20 nm. Le pas de décalage p entre de tels photodétecteurs qui sont juxtaposés dans la surface S peut être 6,0 µm. Dans ces conditions, le facteur d'exaltation G est environ égal à 3710 dans le puits quantique, pour la longueur d'onde de 9 µm, et un rendement d'absorption des photons du rayonnement R dans le volume de ce puits est d'environ 60%. Cette valeur de rendement d'absorption est inférieure à d'autres produites par des structures à puits quantiques multiples, telles que rapportées dans la littérature concernée, mais la faible surface de la structure photosensible 4 à QWIP telle que décrite ci-dessus permet de réduire le courant d'obscurité dans une mesure très importante. En outre, de tels troisièmes modes de réalisation permettent d'obtenir des densités importantes de photodétecteurs dans la surface S, grâce aux dimensions de chaque photodétecteur qui sont encore très petites. La figure 5b montre la résonance d'absorption d'une surface qui contient de tels photodétecteurs juxtaposés, conformes aux troisièmes modes de réalisation et avec les valeurs dimensionnelles qui viennent d'être citées.

Possiblement, des photodétecteurs 10 qui sont conformes à de tels troisièmes modes de réalisation peuvent être utilisés pour détecter du rayonnement électromagnétique selon un mécanisme non-linéaire d'absorption à plusieurs photons dégénérés. De cette façon, il est possible de détecter des rayonnements qui ont des longueurs d'onde plus grandes, notamment à l'intérieur de la bande spectrale 8-12 µm, et d'obtenir des valeurs du courant d'obscurité qui sont encore plus faibles.

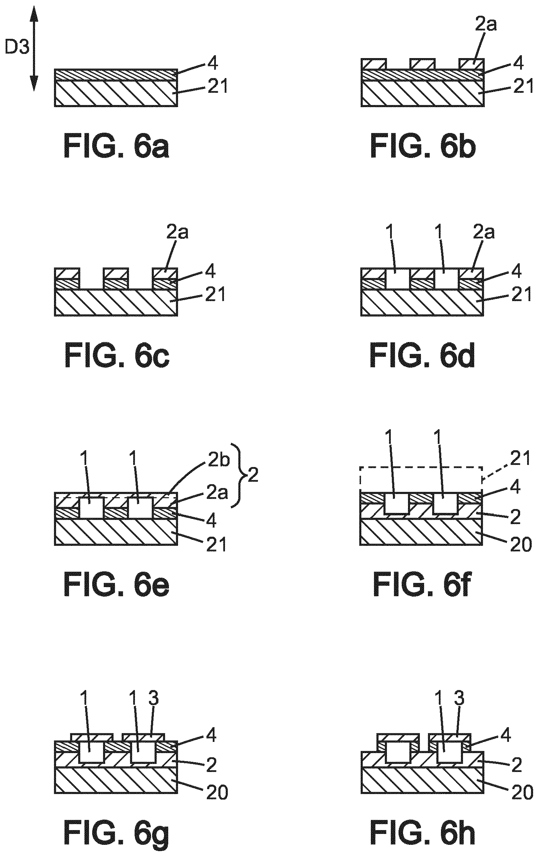

En référence aux figures 6a-6h, on décrit maintenant un procédé de fabrication possible pour des photodétecteurs 10 juxtaposés qui sont conformes à l'invention.

Dans une première étape qui est illustrée par la figure 6a, la structure photosensible 4 est réalisée sur la surface d'un support temporaire 21, par exemple une tranche de silicium monocristallin, de façon à recouvrir continûment le support temporaire 21. La structure photosensible 4 peut être réalisée en déposant un seul ou plusieurs matériaux, en couches successives superposées le cas échéant, selon le mode de réalisation de cette structure, et notamment parmi les trois modes de réalisation qui ont été décrits précédemment. Possiblement, des procédés de dépôt par épitaxie peuvent être utilisés.

Des portions métalliques de séparation 2a, par exemple en or, peuvent ensuite être réalisées par-dessus la structure photosensible 4 (figure 6b), par exemple en utilisant un procédé de lithographie électronique, suivi d'un dépôt d'or et d'une étape de lift-off. Les portions de séparation 2a sont destinées à constituer les portions de la couche de base 2 qui sont intermédiaires entre deux résonateurs de Helmholtz de photodétecteurs 10 qui sont voisins dans la surface S.

La structure photosensible 4 est alors retirée sélectivement entre les portions de séparation 2a (figure 6c), en utilisant un procédé de gravure qui est adapté au(x) matériau(x) de la structure 4. Un tel procédé peut notamment être en phase humide, en mettant en œuvre une solution d'agents de gravure appropriés. Toutefois, cette étape de retrait de la structure photosensible 4 entre les portions de séparation 2a peut être omise pour conserver la structure photosensible 4 avec une extension continue sous les portions de couvercle 3.

Les volumes ainsi libérés, entre des empilements voisins qui sont constitués chacun par une portion résiduelle de structure photosensible 4 et une portion de séparation 2a, peuvent être remplis par une résine isolante (figure 6d). Cette résine constitue le matériau des volumes isolants 1.

Un dépôt complémentaire de métal, notamment d'or, est ensuite effectué (figure 6e), pour former une couche complémentaire 2b qui recouvre continûment les portions de séparation 2a et volumes isolants 1. Les portions de séparation 2a et la couche complémentaire 2b forment la couche de base 2 qui a été introduite plus haut dans la présente description pour chaque photodétecteur 10, aussi appelée première électrode.

Un support définitif 20, par exemple en carbure de silicium, en matériau isolant, ou qui comporte des connexions électriques réalisées antérieurement, est alors collé par-dessus la couche complémentaire 2b. Le support temporaire 21 est ensuite éliminé, par exemple par polissage puis gravure en phase humide. Après retournement, la configuration de la figure 6f est obtenue. Lorsque le support définitif 20 comporte initialement des connexions électriques, celles-ci peuvent constituer les connexions électriques de sortie C1 pour les photodétecteurs 10 en cours de fabrication.

Les portions de couvercle 3, aussi appelées secondes électrodes, sont ensuite formées (figure 6g), par exemple en utilisant une étape de masquage suivie d'une étape de dépôt métallique, d'or dans le cas présent.

Enfin, la structure photosensible 4 est gravée jusqu'à la couche de base 2 entre les portions de couvercle 3 (figure 6h).

Dans cet exemple de procédé de fabrication, la couche de base 2 constitue une première électrode commune aux photodétecteurs 10 qui ont été fabriqués simultanément, et chaque portion de couvercle 3 constitue une seconde électrode séparée qui est dédiée individuellement à l'un des photodétecteurs 10. Dans des réalisations alternatives, la couche de base 2 peut être interrompue entre deux photodétecteurs 10 qui sont voisins, avec une isolation électrique intermédiaire. Alors, les portions de couvercle 3 peuvent être continues entre deux photodétecteurs 10 qui sont voisins, pour former une seconde électrode qui est commune à ces photodétecteurs.

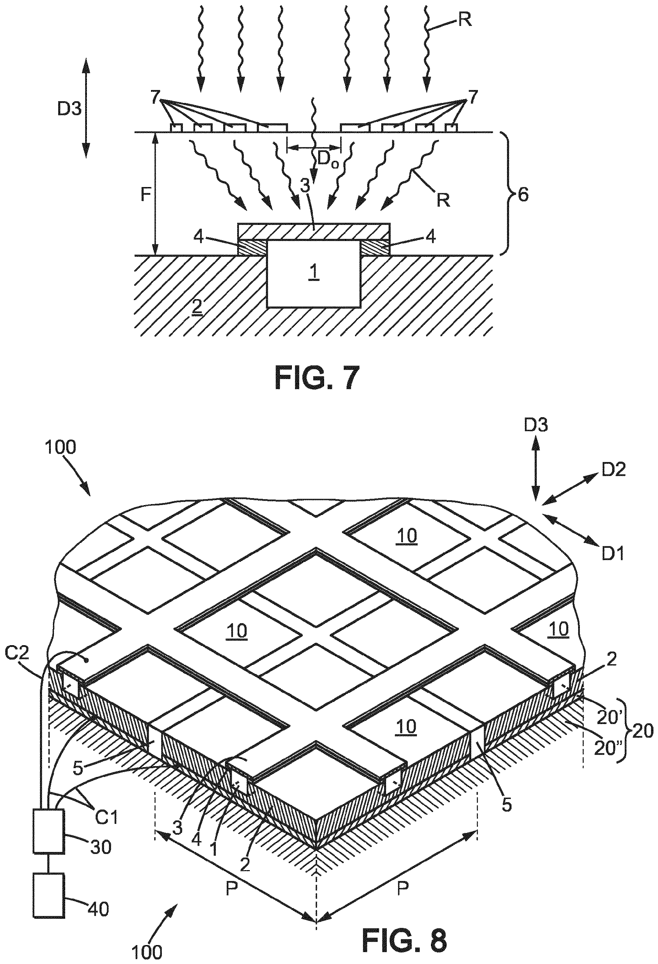

Conformément à la figure 7, un photodétecteur 10 qui est conforme à l'invention peut être associé à une structure de lentille convergente 7. La structure de lentille 7 est avantageusement solidaire du photodétecteur 10, avec une couche intermédiaire 6 d'un matériau qui est transparent au rayonnement R à détecter. La couche 6 possède alors une épaisseur, mesurée selon la direction D3, qui est approximativement égale à la distance focale F de la structure de lentille 7. Ainsi, la structure de lentille 7 focalise le rayonnement R sur le photodétecteur 10, conformément à la section efficace de ce dernier. De multiples méthodes d'assemblage sont connues de l'Homme du métier, pour fixer la couche 6 au photodétecteur 10 d'une part, et pour fixer la structure de lentille 7 sur la couche 6 d'autre part.

La structure de lentille convergente 7 peut être une microlentille plan-convexe, ou bien une structure de Fresnel. Toutefois, de préférence, la structure de lentille 7 peut être une lentille de Huygens, par ailleurs connue de l'Homme du métier. Une telle lentille de Huygens peut être constituée par une couche métallique qui est portée par la couche 6 du matériau transparent, et qui présente un trou central avec des fentes périphériques. Elle est située en vis-vis du photodétecteur 10, avec un alignement selon la direction D3. Le trou central et les fentes périphériques forment un motif de transmission optique qui produit la fonction de focalisation pour le rayonnement R. En particulier, le trou central peut être circulaire et centré par rapport au photodétecteur 10. La distance focale F de la lentille de Huygens, qui est efficace pour la composante spectrale du rayonnement R qui possède la longueur d'onde À, est alors donnée par la formule : F = D₀²/(3·λ), où D₀ est le diamètre du trou central. Dans le cas de la présente invention, l'épaisseur de la couche 6 selon la direction D3 doit correspondre approximativement à la distance focale F pour la longueur d'onde de résonance λᵣ.

Le photodétecteur 10 muni de la structure de lentille 7, tel que représenté dans la figure 7, est particulièrement adapté pour former un pixel d'un capteur d'image 100. De tels pixels sont alors disposés en lignes et en colonnes, selon une matrice telle que représentée dans la figure 8. Pour la clarté de cette figure, la couche de matériau transparent 6, qui peut recouvrir continûment tous les photodétecteurs 10, n'a pas été représentée, ni les structures de lentilles convergentes 7 qui sont dédiées une-à-une au photodétecteurs 10. Dans l'exemple de capteur d'image qui est représenté, tous les photodétecteurs 10 partagent une même couche métallique qui constitue toutes les portions de couvercle 3. Cette couche est texturée en grille à motif carré, afin de permettre au rayonnement R de parvenir aux intervalles de concentration du champ électrique ZC. Elle forme alors une électrode qui est commune à tous les photodétecteurs 10 du capteur d'image 100. Dans ce cas, la couche de base 2 est divisée en portions qui sont isolées électriquement les unes des autres, et dédiées une-à-une aux photodétecteurs 10. La référence 5 désigne un maillage qui est constitué d'un matériau isolant électriquement, tel que de la silice, et qui isole électriquement les portions de couche de base 2 les unes des autres.

La référence 20' désigne un ensemble de couches qui est situé entre les portions de couche de base 2 et une partie de base 20" du support 20. L'ensemble de couches 20' contient les connexions électriques de sortie C1, qui sont raccordées à un circuit d'adressage 30. Un tel circuit d'adressage 30 est aussi connecté en entrée aux portions de couvercle 3 par la connexion de sortie C2, et est connecté en sortie à un circuit de lecture 40, de façon à délivrer les données d'image qui correspondent à chaque image saisie par le capteur 100. De tels circuits d'adressage et de lecture qui sont conçus pour un capteur d'image, sont très connus par ailleurs, si bien qu'il n'est pas nécessaire de les décrire à nouveau ici.

Le pas de décalage p des lignes et des colonnes de pixels dans la matrice du capteur d'image 100, peut être sélectionné en fonction de la ou des longueur(s) du (des) rayonnement(s) à détecter. Ce pas de décalage p dépend notamment des longueurs des branches B1 et B2, selon les directions D1 et D2, des résonateurs de Helmholtz qui sont utilisés.

Enfin, il est possible d'alterner dans la matrice du capteur d'image 100, des photodétecteurs 10 qui sont conformes à l'invention mais qui sont conçus pour détecter avec des sensibilités respectives maximales des rayonnements électromagnétiques dont les longueurs d'onde sont différentes. On obtient ainsi un capteur d'image en couleurs ou un capteur d'image multispectrale. On rappelle qu'un photodétecteur qui est conforme à l'invention et qui est conçu pour détecter un rayonnement électromagnétique autour d'une longueur d'onde voulue, signifie que la structure photosensible est conçue pour présenter une absorption suffisante à cette longueur d'onde, et que le résonateur de Helmholtz est dimensionné pour présenter une résonance à cette même longueur d'onde.

Il est entendu que l'invention peut être reproduite en modifiant des aspects secondaires de celle-ci par rapport aux exemples de réalisation qui ont été décrits en détail, tout en conservant certains au moins des avantages cités. Parmi ces avantages, les principaux sont rappelés maintenant :
- une forte exaltation du champ électrique, qui permet un rendement de détection élevé ;
- une absence de résonances harmoniques, contrairement à l'utilisation d'autres résonateurs tels que des résonateurs de Fabry-Pérot ;
- des valeurs de facteur de qualité pour le résonateur de Helmholtz qui sont assez faibles, permettant au photodétecteur d'être efficace dans un intervalle spectral de détection qui est assez large, notamment avec une largeur spectrale qui peut convenir à des applications d'imagerie ;
- une grande tolérance par rapport à l'inclinaison de la direction d'incidence du rayonnement électromagnétique à détecter, permettant d'associer le photodétecteur avec une lentille de focalisation à ouverture numérique élevée ;
- la possibilité de choisir une sélectivité du photodétecteur par rapport à la polarisation du rayonnement électromagnétique à détecter, ou de réaliser un photodétecteur qui n'est pas sélectif par rapport à cette polarisation, par la forme du résonateur de Helmholtz ;
- des faibles dimensions de chaque photodétecteur ; et
- le photodétecteur peut être réalisé avec des technologies connues et déjà maîtrisées, y compris des technologies de fabrication de circuits intégrés.

En particulier, il est possible de ne disposer la structure photosensible 4 que sur une partie réduite du périmètre du volume isolant 1, en projection dans un plan qui est parallèle à la surface S. La portion de couvercle 3 est alors isolée électriquement de la couche de base 2 en dehors de la structure photosensible 4, par une portion de couche d'un matériau isolant qui peut être avantageusement très mince selon la direction D3, notamment plus mince que la structure photosensible 4. L'exaltation du champ électrique dans la zone de concentration ZC qui contient la structure photosensible 4, est alors encore plus forte de cette façon.

## Revendications

1. Photodétecteur (10) à résonateur de Helmholtz, efficace pour détecter au moins un rayonnement électromagnétique (R) ayant une longueur d'onde comprise entre 0,3 µm et 15 µm, le résonateur de Helmholtz comprenant :
- un volume isolant électriquement (1) ; et
- des faces métalliques (11-14) qui entourent le volume isolant (1) le long d'au moins un chemin en boucle autour dudit volume isolant, en dehors de deux interruptions du chemin en boucle, de sorte que les faces métalliques constituent deux électrodes qui sont séparées l'une de l'autre par au moins un intervalle, dit intervalle de concentration du champ électrique (ZC) et qui contient les interruptions du chemin en bouche ;
ledit intervalle de concentration du champ électrique (ZC) ayant une épaisseur entre les deux électrodes qui est plus petite qu'une épaisseur du volume isolant (1), lesdites épaisseurs étant mesurées selon une direction commune (D3), de sorte que lorsque le rayonnement (R) est incident sur le résonateur, un champ électrique qui est créé par ledit rayonnement dans le résonateur soit plus intense dans l'intervalle de concentration du champ électrique que dans le volume isolant,
le volume isolant (1) et les faces métalliques (11-14) ayant des dimensions adaptées pour produire une résonance du champ électrique dans l'intervalle de concentration du champ électrique (ZC) lorsque la longueur d'onde du rayonnement (R) varie entre 0,3 µm et 15 µm, et le photodétecteur (10) comprenant en outre :
- au moins une structure photosensible (4), qui est à base d'au moins un matériau semiconducteur, qui est absorbante pour le rayonnement (R), qui est disposée au moins en partie dans l'intervalle de concentration du champ électrique (ZC), et qui est en contact électrique avec chacune des deux électrodes ; et
- deux connexions électriques de sortie (C1, C2), qui sont reliées électriquement une-à-une aux deux électrodes, et adaptées pour transmettre un signal électrique de détection qui est généré dans la structure photosensible (4) lorsque le rayonnement (R) est incident sur le résonateur de Helmholtz,
la structure photosensible (4) ayant un intervalle spectral de détection qui contient un intervalle spectral de la résonance du champ électrique.

2. Photodétecteur (10) selon la revendication 1, suivant lequel le volume isolant électriquement (1) est rectiligne et allongé dans une première direction (D1), et chaque intervalle de concentration du champ électrique (ZC) est aussi rectiligne et allongé dans la première direction.

3. Photodétecteur (10) selon la revendication 1, suivant lequel le volume isolant électriquement (1) possède deux branches (B1, B2) rectilignes et allongées qui sont perpendiculaires l'une à l'autre, et chaque intervalle de concentration du champ électrique (ZC) comprend, pour chaque branche du volume isolant, un segment d'intervalle qui est aussi rectiligne et allongé parallèlement à ladite branche, et qui comprend un segment de la structure photosensible (4).

4. Photodétecteur (10) selon l'une quelconque des revendications précédentes, dans lequel les faces métalliques (11-14) forment d'une part une cuvette ayant un fond (13) et deux faces latérales (11, 12) qui s'étendent continûment à partir de deux côtés opposés du fond, et forment d'autre part une face de couvercle (14) qui est en vis-à-vis du fond, de sorte que le volume isolant (1) soit situé entre le fond de la cuvette et la face de couvercle, et simultanément entre les deux faces latérales de la cuvette, et chaque intervalle de concentration du champ électrique (ZC) est situé entre un bord latéral de la face de couvercle et un bord de l'une des faces latérales de la cuvette qui est opposé au fond de ladite cuvette.

5. Photodétecteur (10) selon la revendication 4, dans lequel les deux faces latérales (11, 12) de la cuvette sont parallèles et séparées par une largeur (w_{b}) de cuvette comprise entre 0,05 µm et 0,25 µm, et dans lequel le fond (13) de la cuvette et la face de couvercle (14) sont parallèles et séparées par une épaisseur (h_{b}) du volume isolant (1) comprise entre 0,03 µm et 0,25 µm.

6. Photodétecteur (10) selon l'une quelconque des revendications précédentes, dans lequel l'épaisseur (w_{f}) de chaque intervalle de concentration du champ électrique (ZC), mesurée d'une électrode à l'autre, est comprise entre 10 nm et 100 nm, et chaque intervalle de concentration du champ électrique a une largeur (h_{f}) mesurée parallèlement à l'une au moins des électrodes au niveau dudit intervalle de concentration du champ électrique, qui est comprise entre 10 nm et 50 nm.

7. Photodétecteur (10) selon l'une quelconque des revendications précédentes, dans lequel chaque électrode est constituée au moins en partie par l'un des métaux suivants : or, argent, cuivre, aluminium, ou par un alliage comprenant l'un au moins desdits métaux.

8. Photodétecteur (10) selon l'une quelconque des revendications précédentes, dans lequel chaque structure photosensible (4) comprend l'un parmi une jonction PiN, une portion d'un matériau semiconducteur, et un empilement multicouche à puits quantique.

9. Photodétecteur (10) selon l'une quelconque des revendications précédentes, comprenant en outre une structure de lentille convergente (7) qui est disposée fixement par rapport au résonateur de Helmholtz de façon à focaliser le rayonnement (R) sur ledit résonateur de Helmholtz, lorsque ledit rayonnement est incident sur la structure de lentille.

10. Photodétecteur (10) selon la revendication 9, comprenant en outre une couche (6) d'un matériau transparent pour le rayonnement (R), qui est disposée entre le résonateur de Helmholtz et la structure de lentille (7), de sorte que le résonateur de Helmholtz, chaque structure photosensible (4), la couche du matériau transparent et la structure de lentille soient solidaires au sein d'un bloc rigide.

11. Photodétecteur (10) selon la revendication 9 ou 10, dans lequel la structure de lentille (7) comprend une couche métallique qui est munie d'un trou en vis-à-vis du résonateur de Helmholtz, et munie en outre de fentes disposées autour du trou, pour constituer une lentille de Huygens.

12. Procédé de fabrication d'un photodétecteur (10), ledit photodétecteur étant conforme à l'une quelconque des revendications précédentes, le procédé comprenant les étapes suivantes :
/1/ sur un support temporaire (21), formation de ladite au moins une structure photosensible (4) et d'une portion de matériau isolant électriquement en tant que volume isolant (1), puis d'une première des électrodes par-dessus la structure photosensible et le volume isolant ;
/2/ adhésion d'un support définitif (20) sur la première électrode, d'un côté de ladite première électrode qui est opposé au support temporaire (21) ;
/3/ retrait du support temporaire (21) ; et
/4/ dépôt d'une seconde des électrodes sur la structure photosensible (4) et la portion de matériau isolant, d'un côté de ladite structure photosensible et de ladite portion de matériau isolant qui est opposé au support définitif (20).

13. Capteur d'image (100) comprenant une matrice de photodétecteurs (10) conformes chacun à l'une quelconque des revendications 1 à 11, les photodétecteurs étant disposés à des croisements de lignes et de colonnes de ladite matrice, et le capteur d'image comprenant en outre un système d'adressage (30) adapté pour sélectionner chaque photodétecteur individuellement, et un système de lecture (40) adapté pour lire le signal électrique de détection qui est transmis par les deux connexions électriques de sortie (C1, C2) de l'un quelconque des photodétecteurs lorsque ledit photodétecteur est sélectionné par le système d'adressage.

14. Capteur d'image (100) selon la revendication 13, ayant un pas de lignes ou de colonnes qui est compris entre 2 µm et 20 µm lorsque chaque photodétecteur (10) est efficace pour détecter un rayonnement (R) de longueur d'onde comprise entre 0,8 µm et 15 µm, ou bien ayant un pas de lignes ou de colonnes qui est compris entre 0,1 µm et 2 µm lorsque chaque photodétecteur est efficace pour détecter un rayonnement de longueur d'onde comprise entre 0,3 µm et 0,8 µm.

## Patentansprüche

1. Fotodetektor (10) mit Helmholtz-Resonator, wirksam zum Detektieren von wenigstens einer elektromagnetischen Strahlung (R), welche eine Wellenlänge aufweist, welche zwischen 0,3 µm und 15 µm beträgt, wobei der Helmholtz-Resonator umfasst:
- ein elektrisch isolierendes Volumen (1); und
- metallische Flächen (11-14), welche das isolierende Volumen (1) entlang wenigstens eines Schleifenwegs um das isolierende Volumen herum umgeben, ausgenommen zwei Unterbrechungen des Schleifenwegs derart, dass die metallischen Flächen zwei Elektroden bilden, welche voneinander durch wenigstens ein Intervall getrennt sind, welches Intervall zur Konzentration des elektrischen Felds (ZC) genannt wird und die Unterbrechungen des Schleifenwegs enthält;
wobei das Intervall zur Konzentration des elektrischen Felds (ZC) eine Dicke zwischen den beiden Elektroden aufweist, welche kleiner ist als eine Dicke des isolierenden Volumens (1), wobei die Dicken gemäß einer gemeinsamen Richtung (D3) gemessen werden, so dass wenn die Strahlung (R) auf den Resonator einfällt, ein elektrisches Feld, welches durch die Strahlung in dem Resonator erzeugt wird, in dem Intervall zur Konzentration des elektrischen Felds intensiver ist als in dem isolierenden Volumen,
wobei das isolierende Volumen (1) und die metallischen Flächen (11-14) Abmessungen aufweisen, welche dazu eingerichtet sind, eine Resonanz des elektrischen Felds in dem Intervall zur Konzentration des elektrischen Felds (ZC) zu erzeugen, wenn die Wellenlänge der Strahlung (R) zwischen 0,3 µm und 15 µm variiert, und wobei der Fotodetektor (10) ferner umfasst:
- wenigstens eine fotosensible Struktur (4), welche auf Grundlage von wenigstens einem Halbleitermaterial ist, welches für die Strahlung (R) absorbierend ist, welche wenigstens teilweise in dem Intervall zur Konzentration des elektrischen Felds (ZC) angeordnet ist und welche in elektrischem Kontakt mit jeder der beiden Elektroden ist; und
- zwei elektrische Ausgangsverbindungen (C1, C2), welche elektrisch eins-zueins mit den beiden Elektroden verbunden sind und dazu eingerichtet sind, ein elektrisches Detektionssignal zu übertragen, welches in der fotosensiblen Struktur (4) erzeugt wird, wenn die Strahlung (R) auf den Helmholtz-Resonator einfällt,
wobei die fotosensible Struktur (4) ein spektrales Detektionsintervall aufweist, welches ein spektrales Resonanzintervall des elektrischen Felds enthält.

2. Fotodetektor (10) nach Anspruch 1, wobei das elektrisch isolierende Volumen (1) geradlinig und in einer ersten Richtung (D1) länglich ist, und wobei jedes Intervall zur Konzentration des elektrischen Felds (ZC) ebenfalls geradlinig und in der ersten Richtung länglich ist.

3. Fotodetektor (10) nach Anspruch 1, wobei das elektrisch isolierende Volumen (1) zwei geradlinige und längliche Zweige (B1, B2) besitzt, welche zueinander senkrecht sind, und wobei jedes Intervall zur Konzentration des elektrischen Felds (ZC) für jeden Zweig des isolierenden Volumens ein Intervallsegment umfasst, welches ebenfalls geradlinig und parallel zu dem Zweig länglich ist, und welches ein Segment der fotosensiblen Struktur (4) umfasst.

4. Fotodetektor (10) nach einem der vorhergehenden Ansprüche, wobei die metallischen Flächen (11-14) einerseits eine Senke bilden, welche einen Boden (13) und zwei laterale Flächen (11, 12) aufweist, welche sich kontinuierlich ausgehend von zwei entgegengesetzten Seiten des Bodens erstrecken, und andererseits eine Deckelfläche (14) bilden, welche gegenüber des Bodens liegt, so dass das isolierende Volumen (1) zwischen dem Boden der Senke und der Deckelfläche platziert ist, sowie gleichzeitig zwischen den beiden lateralen Flächen der Senke, und jedes Intervall zur Konzentration des elektrischen Felds (ZC) zwischen einem lateralen Rand der Deckelfläche und einem Rand von einer der beiden lateralen Flächen der Senke platziert ist, welche dem Boden der Senke entgegengesetzt ist.

5. Fotodetektor (10) nach Anspruch 4, wobei die beiden lateralen Flächen (11, 12) der Senke parallel und durch eine Größe (w_{b}) der Senke getrennt sind, welche zwischen 0,05 µm und 0,25 µm beträgt, und wobei der Boden (13) der Senke und die Deckelfläche (14) parallel und durch eine Dicke (h_{b}) des isolierenden Volumens (1) getrennt sind, welche zwischen 0,03 µm und 0,25 µm beträgt.

6. Fotodetektor (10) nach einem der vorhergehenden Ansprüche, wobei die Dicke (w_{f}) von jedem Intervall zur Konzentration des elektrischen Felds (ZC), gemessen von einer Elektrode zu der anderen, zwischen 10 nm und 100 nm beträgt, und jedes Intervall zur Konzentration des elektrischen Felds eine Größe (h_{f}), gemessen parallel zu wenigstens einer der Elektroden auf dem Niveau des Intervalls zur Konzentration des elektrischen Felds, aufweist, welche zwischen 10 nm und 50 nm beträgt.

7. Fotodetektor (10) nach einem der vorhergehenden Ansprüche, wobei jede Elektrode wenigstens teilweise durch eines der folgenden Metalle gebildet ist: Gold, Silber, Kupfer, Aluminium oder durch eine Legierung, welche wenigstens eines dieser Metalle umfasst.

8. Fotodetektor (10) nach einem der vorhergehenden Ansprüche, wobei jede fotosensible Struktur (4) eines aus einem PiN-Übergang, einem Abschnitt eines Halbleitermaterials und einem mehrschichtigen Stapel mit Quantentöpfen umfasst.

9. Fotodetektor (10) nach einem der vorhergehenden Ansprüche, ferner umfassend eine Sammellinsen-Struktur (7), welche derart fest bezüglich des Helmholtz-Resonators angeordnet ist, dass die Strahlung (R) an dem Helmholtz-Resonator fokussiert wird, wenn die Strahlung auf die Linsenstruktur einfällt.

10. Fotodetektor (10) nach Anspruch 9, ferner umfassend eine Schicht (6) aus einem für die Strahlung (R) transparenten Material, welche derart zwischen dem Helmholtz-Resonator und der Linsenstruktur (7) angeordnet ist, dass der Helmholtz-Resonator, jede fotosensitive Struktur (4), die Schicht des transparenten Materials und die Linsenstruktur verbunden innerhalb eines festen Blocks sind.

11. Fotodetektor (10) nach Anspruch 9 oder 10, wobei die Linsenstruktur (7) eine metallische Schicht umfasst, welche mit einem Loch gegenüber dem Helmholtz-Resonator versehen ist und ferner mit Spalten versehen ist, welche um das Loch herum angeordnet sind, um eine Huygens-Linse zu bilden.

12. Verfahren zum Herstellen eines Fotodetektors (10), wobei der Fotodetektor gemäß einem aus den vorhergehenden Ansprüche ist, wobei das Verfahren die folgenden Schritte umfasst:
/1/ auf einem temporären Träger (21), Bilden der wenigstens einen fotosensiblen Struktur (4) und eines Abschnitts aus elektrisch isolierendem Material als isolierendes Volumen (1), dann einer ersten der Elektroden über der fotosensiblen Struktur und dem isolierenden Volumen;
/2/ Anhaften eines endgültigen Trägers (20) auf der ersten Elektrode an einer Seite der ersten Elektrode, welche dem temporären Träger (21) entgegengesetzt ist;
/3/ Entfernen des temporären Trägers (21); und
/4/ Anlagern einer zweiten der Elektroden auf der fotosensiblen Struktur (4) und dem Abschnitt aus isolierendem Material an einer Seite der fotosensiblen Struktur und des Abschnitts aus isolierendem Material, welcher dem endgültigen Träger (20) entgegengesetzt ist.

13. Bildaufnahmevorrichtung (100), umfassend eine Matrix von Fotodetektoren (10), jeweils gemäß einem der Ansprüche 1 bis 11, wobei die Fotodetektoren an Kreuzungspunkten von Linien und Spalten der Matrix angeordnet sind, und wobei die Bildaufnahmevorrichtung ferner ein Adressierungssystem (30), welches dazu eingerichtet ist, jeden Fotodetektor individuell auszuwählen, sowie ein Lesesystem (40) umfasst, welches dazu eingerichtet ist, das elektrische Detektionssignal zu lesen, welches von den beiden elektrischen Ausgangsverbindungen (C1, C2) von einem beliebigen der Fotodetektoren übertragen wird, wenn der Fotodetektor von dem Adressierungssystem ausgewählt ist.

14. Bildaufnahmevorrichtung (100) nach Anspruch 13, aufweisend einen Linien- oder Spaltenabstand, welcher zwischen 2 µm und 20 µm beträgt, wenn jeder Fotodetektor (10) wirksam ist, um eine Strahlung (R) einer Wellenlänge zu detektieren, welche zwischen 0,8 µm und 15 µm beträgt, oder aber einen Linien- oder Spaltenabstand aufweist, welcher zwischen 0,1 µm und 2 µm beträgt, wenn jeder Fotodetektor wirksam ist, eine Strahlung einer Wellenlänge zu detektieren, welche zwischen 0,3 µm und 0,8 µm beträgt.

## Claims

1. Photodetector (10) which includes a Helmholtz resonator, efficient for detecting at least one electromagnetic radiation (R) having a wavelength comprised between 0.3 µm and 15 µm, the Helmholtz resonator comprising:
- an electrically insulating volume (1); and
- metal faces (11-14) that surround the insulating volume (1) along at least one looped path that forms a loop around said insulating volume, excepting two interruptions of the looped path, so that the metal faces form two electrodes that are separated from each other by at least one gap, called electric-field-concentrating gap (ZC) and which contains the interruptions of the looped path;
said electric-field-concentrating gap (ZC) having a thickness between both electrodes that is smaller than a thickness of the insulating volume (1), said thicknesses being measured along a common direction (D3), so that when the radiation (R) is incident on the resonator, an electric field that is created by said radiation in the resonator is more intense in the electric-field-concentrating gap than in the insulating volume,
the insulating volume (1) and the metal faces (11-14) having dimensions suitable for producing a resonance of the electric field in the electric-field-concentrating gap (ZC) when the wavelength of the radiation (R) varies between 0.3 µm and 15 µm, and the photodetector (10) furthermore comprising:
- at least one photosensitive structure (4), which is based on at least one semiconductor, which is absorbing for the radiation (R), which is placed at least partially in the electric-field-concentrating gap (ZC), and which is in electrical contact with each of the two electrodes; and
- two output electrical connections (C1, C2), which are electrically connected one-by-one to the two electrodes, and which are suitable for transmitting a detection electrical signal that is generated in the photosensitive structure (4) when the radiation (R) is incident on the Helmholtz resonator,
the photosensitive structure (4) having a detection spectral interval that contains a spectral interval of the resonance of the electric field.

2. Photodetector (10) according to Claim 1, wherein the electrically insulating volume (1) is rectilinear and elongate in a first direction (D1), and each electric-field-concentrating gap (ZC) is also rectilinear and elongate in the first direction.

3. Photodetector (10) according to Claim 1, wherein the electrically insulating volume (1) has two rectilinear and elongate branches (B1, B2) that are perpendicular to each other, and each electric-field-concentrating gap (ZC) comprises, for each branch of the insulating volume, a gap segment that is also rectilinear and elongate parallel to said branch, and that comprises a segment of the photosensitive structure (4).

4. Photodetector (10) according to any one of the preceding claims, wherein the metal faces (11-14) form, on the one hand, a cuvette having a bottom (13) and two lateral faces (11, 12) that extend continuously from two opposite sides of the bottom, and form, on the other hand, a cover face (14) that is located facing the bottom, so that the insulating volume (1) is located between the bottom of the cuvette and the cover face, and simultaneously between both lateral faces of the cuvette, and each electric-field-concentrating gap (ZC) is located between a lateral edge of the cover face and an edge of one of the lateral faces of the cuvette, which edge is opposite the bottom of said cuvette.

5. Photodetector (10) according to Claim 4, wherein both lateral faces (11, 12) of the cuvette are parallel and separated by a cuvette width (w_{b}) comprised between 0.05 µm and 0.25 µm, and wherein the bottom (13) of the cuvette and the cover face (14) are parallel and separated by a thickness (h_{b}) of the insulating volume (1) comprised between 0.03 µm and 0.25 µm.

6. Photodetector (10) according to any one of the preceding claims, wherein the thickness (w_{f}) of each electric-field-concentrating gap (ZC), measured from one electrode to the other, is comprised between 10 nm and 100 nm, and each electric-field-concentrating gap has a width (h_{f}), measured parallel to at least one of the electrodes at said electric-field-concentrating gap, that is comprised between 10 nm and 50 nm.

7. Photodetector (10) according to any one of the preceding claims, wherein each electrode is at least partially made of one of the following metals: gold, silver, copper, aluminium, or with an alloy comprising at least one of said metals.

8. Photodetector (10) according to any one of the preceding claims, wherein each photosensitive structure (4) comprises one among a PiN junction, a portion of a semiconductor material, and a quantum-well multilayer stack.

9. Photodetector (10) according to any one of the preceding claims, furthermore comprising a convergent lens structure (7) that is fixedly placed with respect to the Helmholtz resonator so as to focus the radiation (R) on said Helmholtz resonator, when said radiation is incident on the lens structure.

10. Photodetector (10) according to Claim 9, furthermore comprising a layer (6) of a material that is transparent to the radiation (R), which layer is placed between the Helmholtz resonator and the lens structure (7), so that the Helmholtz resonator, each photosensitive structure (4), the layer of the transparent material and the lens structure are securely fastened together within a rigid block.

11. Photodetector (10) according to Claim 9 or 10, wherein the lens structure (7) comprises a metal layer that is provided with a hole facing the Helmholtz resonator, and furthermore provided with slits placed around the hole, in order to form a Huygens lens.

12. Process for fabricating a photodetector (10), said photodetector being according to any one of the preceding claims, the process comprising the following steps:
/1/ on a temporary support (21), forming said at least one photosensitive structure (4) and a portion of electrically insulating material as the insulating volume (1), then a first one of the electrodes above the photosensitive structure and the insulating volume;
/2/ bonding a final support (20) to the first electrode, on a side of said first electrode that is opposite the temporary support (21);
/3/ removing the temporary support (21); and
/4/ depositing a second one of the electrodes on the photosensitive structure (4) and the portion of insulating material, on a side of said photosensitive structure and of said portion of insulating material that is opposite the final support (20).

13. Image sensor (100) comprising a matrix array of photodetectors (10) each of which is according to any one of Claims 1 to 11, the photodetectors being placed at intersections of rows and columns of said matrix array, and the image sensor furthermore comprising an addressing system (30) suitable for selecting each photodetector individually, and a reading system (40) suitable for reading the detection electrical signal that is transmitted by the two output electrical connections (C1, C2) of any one of the photodetectors when said photodetector is selected by the addressing system.

14. Image sensor (100) according to Claim 13, having a row or column pitch that is comprised between 2 µm and 20 µm when each photodetector (10) is efficient for detecting a radiation (R) with wavelength comprised between 0.8 µm and 15 µm, or having a row or column pitch that is comprised between 0.1 µm and 2 µm when each photodetector is efficient for detecting a radiation of wavelength comprised between 0.3 µm and 0.8 µm.
